# EUROPEAN PATENT APPLICATION

(11) **EP 2 772 767 A1**
(43) Date of publication of application: **03.09.2014**
(21) Application number: 14157325.3
(22) Date of filing: 28.02.2014
(51) Int. Cl.: G01R 27/20, G01V 3/02

(54) **Earth ground tester with remote control**

(30) Priority: 02.03.2013 IN CH09152013
(71) Applicant: Fluke Corporation, Everett, WA 98203 (US)
(72) Inventor: Kawasaki, Cy, Renton, WA 98059 (US); Shrivastav, Prabhat, Karnataka (IN)
(74) Representative: Lunt, Mark George Francis

(57) **Abstract**

Methods and apparatuses for measuring earth ground resistivity are provided. A main unit (10) can be configured to couple to each of a plurality of electrodes (14, 16, 18) over a respective wire (20, 22, 24, 26), perform a resistance measurement over the plurality of electrodes, and transmit an induction signal over one or more of the respective wires indicating a representation of a resistance value calculated as part of the resistance measurement. A remote unit (12) can be configured to detect the induction signal over the one or more of the respective wires using an inductance mechanism (30), process the induction signal to determine the representation of the resistance value, and render the representation of the resistance value on an interface of the remote unit.

## Description

### TECHNICAL FIELD

Aspects described herein generally relate to a method and apparatus for performing multiple ground resistance and soil resistivity measurements.

### BACKGROUND

A lack of good grounding is undesirable and increases the risk of electrical equipment failure. The absence of an effective grounding system can lead to various problems, such as instrumentation errors, harmonic distortion issues, power factor problems, and a host of possible intermittent dilemmas. If fault currents have no path to the ground through a properly designed and maintained grounding system, they will find unintended paths. Furthermore, a good grounding system is also used to prevent damage to industrial plants and equipment and is therefore desired to improve the reliability of equipment and reduce the likelihood of damage due to lightning or fault currents.

Over time, corrosive soils with high moisture content, high salt content, and high temperatures can degrade ground rods and their connections. Thus, although the grounding system may have had low earth ground resistance values when initially installed, the resistance of the grounding system can increase over time if the ground rods, or other elements of a grounding system, start to corrode. Grounding testers are useful troubleshooting tools for dealing with such issues as intermittent electrical problems, which could be related to poor grounding or poor power quality. Using such ground testers allows for periodic checking of all grounds and ground connections.

During these periodic checks, if an increase in resistance of more than 20% or other threshold is measured, investigation of the source of the problem may be undertaken so that corrections may be made to lower the resistance (e.g., by replacing or adding ground rods to the ground system). Such periodic checks may involve conducting established techniques such as fall-of-potential tests, selective measurements, soil resistivity tests, which may also form part of a geological survey, two-pole measurements and/or the like. To achieve accurate results with present grounding test systems, such tests tend to be extremely time consuming and labour intensive. In particular, when dealing with measurements involving high-voltage applications, such as electricity pylons, the tests need to be conducted with caution.

The aforementioned grounding test procedures all require a considerable amount of effort walking back and forth several times between the various electrodes connected to a testing device to ensure accuracy and/or perform multiple measurements. Specifically, once a testing device has been set up for implementing the aforementioned techniques according to the prior art, incorrect or anomalous results can occur due to inadequate contact between the electrodes and test device, such as loose clips, insufficient conduction, unsuitable placement of the electrodes, etc. Hence, setup adjustment and repeat measurements may be necessary to obtain accurate testing results. For example, an operator may be required to check all connections at the various electrodes, which are often placed at large distances from one another.

Performing this repeat measurement/correction procedure with a single operator tends to be extremely time-consuming and labour-intensive. A common solution to reduce the wasted time and effort associated with this procedure is to provide more than one operator to conduct a single test procedure; however this is often not realistic or possible due to the availability of such further personnel. Furthermore, this solution is neither efficient nor convenient and incurs considerable extra expense.

### SUMMARY

The following presents a simplified summary of one or more aspects to provide a basic understanding thereof. This summary is not an extensive overview of all contemplated aspects, and is intended to neither identify key or critical elements of all aspects nor delineate the scope of any or all aspects. Its sole purpose is to present some concepts of one or more aspects in a simplified form as a prelude to the more detailed description that follows.

According to one aspect, a testing device is provided that may be used to conduct one or more of the aforementioned testing techniques. The testing device includes both a main unit and a remote unit adapted to communicate with one another over wires connected to the electrodes. After configuring the testing device for measuring according to the desired measurement technique, the remote unit can initiate measurement by sending an inductive signal over a wire connecting the main unit to one of the electrodes. Similarly, the resulting measurement values, or representations thereof, can be provided to the remote unit as an inductive signal sent over the wire. The main unit and remote unit can be configured with mechanisms to transmit and receive the inductive signals. This allows a single operator to perform measurements using the remote unit while located away from the main unit, or at least verify that the measurements are within an acceptable range, which can relieve the operator from constantly having to walk back and forth placing electrodes in different positions. In one example, this can also mitigate the need to return to the main unit of the testing device to consult a display for measurement results.

To the accomplishment of the foregoing and related ends, the one or more aspects comprise the features hereinafter fully described and particularly pointed out in the claims. The following description and the annexed drawings set forth in detail certain illustrative features of the one or more aspects. These features are indicative, however, of but a few of the various ways in which the principles of various aspects may be employed, and this description is intended to include all such aspects and their equivalents.

### BRIEF DESCRIPTION OF THE DRAWINGS

The disclosed aspects will hereinafter be described in conjunction with the appended drawings, provided to illustrate and not to limit the disclosed aspects, wherein like designations may denote like elements.
FIGURE 1 shows an example testing device for conducting a 4-pole fall-of-potential test according to one example.
FIGURE 2 shows an example testing device for performing selective measurements.
FIGURE 3 shows an example testing device for measuring soil resistivity with 4-pole tests.
FIGURE 4 illustrates an example methodology for transmitting measured resistance values via an induction signal.
FIGURE 5 illustrates an example methodology for requesting a measurement via an induction signal.
FIGURE 6 illustrates an example methodology for determining and transmitting a representation of a resistance value.

### DETAILED DESCRIPTION

Reference will now be made in detail to various aspects, one or more examples of which are illustrated in the accompanying drawings. Each example is provided by way of explanation, and not limitation of the aspects. In fact it will be apparent to those skilled in the art that modifications and variations can be made in the described aspects without departing from the scope or spirit thereof. For instance, features illustrated or described as part of one example may be used on another example to yield a still further example. Thus, it is intended that the described aspects cover such modifications and variations as come within the scope of the appended claims and their equivalents.

The term "or" is intended to mean an inclusive "or" rather than an exclusive "or." That is, unless specified otherwise, or clear from the context, the phrase "X employs A or B" is intended to mean any of the natural inclusive permutations. That is, the phrase "X employs A or B" is satisfied by any of the following instances: X employs A; X employs B; or X employs both A and B. In addition, the articles "a" and "an" as used in this application and the appended claims should generally be construed to mean "one or more" unless specified otherwise or clear from the context to be directed to a singular form.

Various aspects or features will be presented in terms of systems that may include a number of devices, components, modules, and the like. It is to be understood and appreciated that the various systems may include additional devices, components, modules, etc. and/or may not include all of the devices, components, modules, etc., discussed in connection with the figures. A combination of these approaches may also be used.

In various examples described herein, a testing device includes a main unit and a remote unit for performing earth resistance or soil resistivity measurements. The main unit can perform the measurement, and the remote unit can initiate the measurement by, and receive results from, the main unit. For instance, the main unit is coupled to one or more electrodes (e.g., ground rods, stakes, etc.) via respective wires to check resistance thereof. The main unit and remote unit can be configured to communicate with one another by transmitting and receiving induction signals over the wires, where the signals can specify a request to initiate resistance measurements, a representation of one or more results of such measurements, etc. In one example, the remote unit can couple to one of the wires and can transmit an induction signal over the wire to initiate a measurement. The main unit can receive the induction signal over the wire connected to the main unit and accordingly perform the measurement. Similarly, the main unit can communicate results of the measurement to the remote unit by transmitting an induction signal over the wire, which can be received and processed at the remote unit.

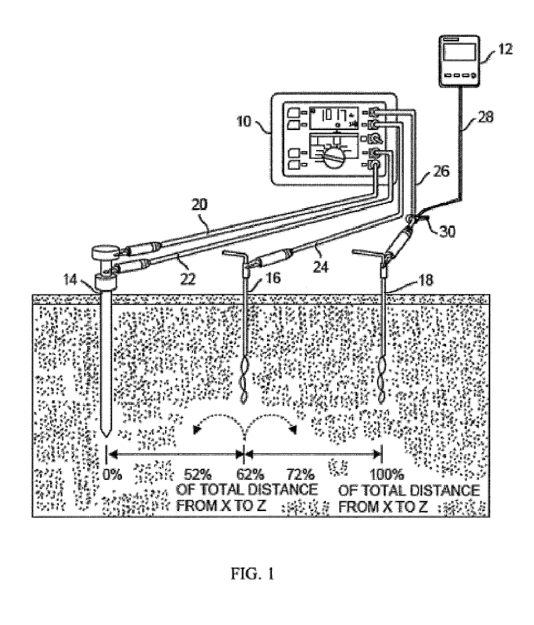

FIGURE 1 illustrates an example testing device for measuring ground resistance of a ground rod. The testing device includes a main unit 10 and a remote unit 12. The main unit 10 is coupled to a series of electrodes, including a ground rod 14 and a plurality of stakes 16 and 18 by respective wires 20, 22, 24, and/or 26. The stakes 16 and 18 are deployed into soil at predetermined distances from one another. As depicted, the wires 20, 22, 24, and/or 26 can each include a clamp for coupling to the electrodes 14, 16, and/or 18, though it is to be appreciated that other connecting mechanisms are possible as well. In this regard, the main unit 10 can perform ground resistance measurements for ground rod 14 based on additional measurements of stakes 16 and 18, as described further herein.

The remote unit 12 includes an inductance mechanism 30 configured to transmit induction signals (e.g., as electrical currents) over wires, and/or pick up induction signals on the wires. In one example, the inductance mechanism 30 can be a clamp or other coupling mechanism, such as a current clamp, that is able to couple to the wires to transmit or pick up induction signals (e.g., via a magnetic core). The inductance mechanism 30 can be coupled to the remote unit 12 by a wire 28 to allow sending induction signals from the remote unit 12 to the inductance mechanism 30 and/or sending induction signals observed by the inductance mechanism 30 to the remote unit 12.

The main unit 10 can also include an inductance mechanism (not shown). In one example, the inductance mechanism of the main unit 10 can be built into the unit (e.g., at a port that receives test leads connected to wires 20, 22, 24, and/or 26) to observe and/or transmit induction over wires 20, 22, 24, and/or 26 plugged into the main unit 10. Thus, for example, the remote unit 12 can transmit an induction signal via the inductance mechanism 30 to cause initiation of a measurement, such as a measurement of ground or soil resistivity, at the main unit 10. In one example, the main unit 10 includes a selection mechanism (such as a selector knob) for specifying a type of measurement, and the main unit 10 performs the selected measurement based on receiving the induction signal. In another example, the induction signal from the remote unit 12 can specify a type of measurement or one or more related parameters (e.g., based on selection thereof at the remote unit 12).

In any case, where the inductance mechanism 30 is coupled to (e.g., clamped around) the wire 26 as shown in the example of FIGURE 1, the main unit 10 can detect the induction signal on the wire 26 (e.g., or on a test lead thereof) coupled to the main unit 10 using its built-in inductance mechanism. It is to be appreciated that the remote unit 12 can transmit the induction signal via the inductance mechanism 30 over substantially any of the wires 20, 22, 24, and/or 26, for detection by main unit 10. The remote unit 12 can transmit the induction signal, in one example, based on detecting activation of a button or other selection on the remote unit 12, which can indicate a desire to perform the measurement.

The main unit 10 can detect and interpret the induction signal as indicating a request to initiate the measurement, and can accordingly perform the selected measurement. For example, detecting and/or interpreting the induction signal can include the main unit 10 detecting a certain modulation sequence or other characteristics of the induction signal that are meant to indicate initiation of the measurement. For example, the inductance mechanism 30 can use variance of a modulation of the induction signal, a transmission pattern of the induction signal, strength of the induction signal, etc.. to indicate measurement initiation, and the main unit 10 can detect such characteristics of the signal in determining to initiate the measurement. In an example, the main unit 10 can transmit an induction signal over the wire 26 (and/or wires 20, 22, and 24) confirming the start of the measurement, which the remote unit 12 can obtain as an indication that the measurement has begun.

Following the measurement, the main unit 10 can subsequently communicate a representation of results of the measurement to the remote unit 12 by transmitting an induction indicative of the results over wire 26 (e.g., and/or wires 20, 22, and 24) using its built-in inductance mechanism. The inductance mechanism 30 can observe the induction and provide related information to the remote unit 12 for processing and/or rendering thereof. In this regard, the remote unit 12 can process the induction signal to determine the representation of the measurement result and can appropriately indicate the representation via an interface. In an example, the remote unit 12 can similarly transmit an induction signal to indicate confirmation of receiving the results from the main unit 10 via the inductance mechanism 30 over one or more of the wires 20, 22, 24, and/or 26. Thus, the remote unit 12 can be used to initiate measurements and obtain results by coupling the inductance mechanism 30 of the remote unit 12 to one of the wires 20, 22, 24, and/or 26, without requiring a user to directly interact with the main unit 10.

The remote unit 12, in an example, can include a digital display (e.g., light emitting diode (LED), liquid crystal display (LCD) or similar displays), a plurality of lights or other visual indicators, a speaker or other audio output device, or substantially a mechanism for outputting information to a user. Thus, rendering the resistance measurement results obtained in the induction signal detected by the inductance mechanism 30 can include displaying the results on the display, illuminating a number of lights indicative of a range of the results, sounding audible indicators, such as a read measurement, a number of tones, etc. The main unit 10 can also include a display, as shown, such that use of the remote unit 12 is not necessary to complete the measurements or read accurate results.

In yet another embodiment, the remote unit 12 comprises a handheld and portable device, which may be removably coupled with the main unit 10 mechanically and/or electrically. This embodiment allows convenient transportation of both units of the testing device between measurement sites. In addition, in one example, the main unit 10 acts as a dock for the remote unit 12 (e.g., for commonly charging the remote unit 12 along with the main unit 10 using a single power source).

With respect to ground system resistance measurements, for example, it may be desirable that the respective resistances of the auxiliary electrodes 16 and 18 are not too high compared to the resistance of the earth ground rod 14 being tested to achieve appropriate levels of accuracy when performing earth ground measurements. In geologically difficult conditions where high contact resistances between the electrodes 16 and 18 and the earth exist, the operator can observe high ground system resistance indicated on the remote unit 12, via an induction signal indicative of a representation of the resistance, and can take appropriate counter measures should the value be considered too high without consulting the main unit 10. As described, the resistance value can be indicated by the remote unit 12 using one or more of a plurality of lights, an LED display, etc. Such countermeasures may include tamping down the soil around the electrodes 16 and/or 18, pouring water around the electrodes 16 and/or 18, etc., to improve contact at the soil/electrode interface.

Thereafter, the operator can easily repeat the measurements by again requesting initiation thereof and obtaining at least a representation of the results via the remote unit 12 to assess the success of the implemented countermeasures without having to walk to the main unit 10 to observe such. Hence, this embodiment advantageously increases the efficiency of performing such measurements by eliminating a considerable amount of time and effort, which would normally be expended by at least one operator (and possibly several) walking back and forth between multiple electrodes and the main unit 10.

In one further example, the main unit 10 can determine an electrode having a high resistance (e.g., beyond a threshold when compared to other electrodes), and can indicate the electrode in the induction signal to the remote unit 12 (e.g., by varying characteristics of the induction signal, such as modulation, transmission pattern, strength, etc.). The remote unit 12 can determine the electrode based on the induction signal characteristics as received by the inductance mechanism 30, and can render a resulting indicator of the high resistance at the given electrode. Thus, a user can determine which electrode to reposition based on the indication by the remote unit 12, in this example.

### Fall-of Potential Measurement

One method of measuring the ability of an earth ground system or an individual electrode to dissipate energy from a site is the "fall-of-potential" test.

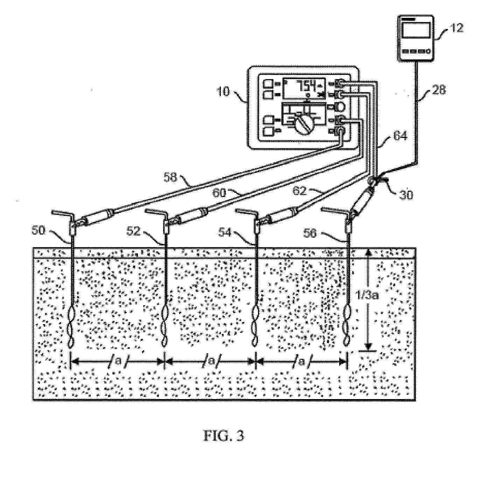

For example, referring again to FIGURE 1, an earth electrode or ground rod 14 to be tested is disconnected from its connection to the grounding system to avoid obtaining incorrect (e.g., too low) earth resistance measurements, which can be caused by parallel grounding. The main unit 10 of the testing device is then connected to the earth electrode 14, which may then be used as a first current electrode 14. Techniques of performing a fall-of-potential test include a four-point or 4-pole testing, as illustrated in FIGURE 1, 3-pole testing, 2-pole testing, or a greater number of poles, etc. For a 3- or 4-pole fall-of-potential test, two further (auxiliary) electrodes 16 and 18 are provided (generally in the form of respective earth stakes), wherein one of the electrodes 18 is placed in the soil at a predetermined distance away from the earth electrode 14 to be used as a second current electrode 18. The other auxiliary electrode 16 is subsequently placed in the soil, for example, along a direct line between the earth electrode 14 and current electrode 18 to be used as a voltage probe 16. Another common measurement topology (not shown) comprises placing the electrodes at a different angle to one another (e.g., 90 degrees). The two auxiliary electrodes 16 and 18 are also connected to the main unit 10 of the testing device. The wires 20 and 22 are connected to the ground electrode 14, the wire 24 is connected to the auxiliary electrode 16, and the wire 26 is connected to the auxiliary electrode 18.

In a next step, for example, the remote unit 12 can cause initiation of a measurement by transmitting an induction signal over the wire 20, 22, 24, or 26 via the inductance mechanism 30, which can be clamped around the corresponding wire. In one example, this can occur on a wire of the last ground stake inserted in the ground to mitigate walking by the operator to initiate the measurement. The main unit 10 can pick up the induction signal over the respective wire 20, 22, 24, or 26, and determine that the induction signal relates to initiating the measurement. In this example, the main unit 10 of the testing device can initiate a measurement by generating a predetermined (known) current between the current electrode 18 and the earth electrode 14 using the wires 20 and 26. The drop in voltage potential along this current path can then be measured at predetermined points along this direct line between the current electrode 18 and the earth electrode 14 by the probe 16 using the wire 24 (e.g., a value for the potential drop between the earth electrode 14 and the probe 16 may be obtained). The wire 22 connected to the ground electrode 14 can be used to eliminate influence of any portion of the wires 20, 24, and 26, or related test leads plugged into the main unit 10.

Using Ohm's Law (*V* = *IR*), where V is the potential voltage difference, I is the predetermined current, and R is the resistance in units of ohms, the main unit 10 of the testing device is then able to automatically calculate the resistance of the earth electrode 14 based on the known current generated and the measured drop in potential. The main unit 10 can transmit the resistance, or some relative representation thereof, by transmitting an induction over one or more of the wires 20, 22, 24, and/or 26, and the remote unit 12 can accordingly detect the induction and render the measurement result or representation thereof based on the received induction signal. In an example, a relative representation of the resistance can include an index indicative of ranges of resistances. In a specific example, the range may be 1-8, where each index indicates a range of resistances in Ohms, such as:
1: 0 to 0.5
2: 0.5 to 1
3: 1 to 5
4: 5 to 10
5: 10 to 50
6: 50 to 100
7: 100 to 200
8: 200+

Thus, where such a representation is received in the induction signal from the main unit 10, the remote unit 12 can determine the index and appropriately display the representation (e.g., as a number of lights, which can relate to the index number received, as the range associated with the received index on an LCD, and/or the like). If the earth electrode 14 is in parallel or series with other ground rods (not shown), the resistance value derived comprises the total resistance value of all ground rods.

To achieve a high degree of accuracy when performing a 3- or 4-pole ground resistance test, the auxiliary current electrode 18 can be placed outside the sphere of influence of the earth electrode 14 being tested and the inner probe 16. If the auxiliary current electrode 18 is not placed outside the sphere of influence, the effective areas of resistance may overlap and invalidate any measurements made by the testing device. Also, in general, the electrode 18 should extend below the surface at a distance greater than that of the depth of the earth ground rod 14 being tested. The following table provides examples for the appropriate setting of the auxiliary electrodes 16 and 18.

| Depth of Earth Electrode 14 (meters) | Distance to Probe 16 (meters) | Distance to Current Electrode 18 (meters) |
|---|---|---|
| 2 | 15 | 25 |
| 3 | 20 | 30 |
| 6 | 25 | 40 |
| 10 | 30 | 50 |

In testing the accuracy of the results and ensuring that the auxiliary electrodes 16 and 18 are outside the spheres of influence, the probe 16 may be, for example, repositioned in accordance with the so-called 62% rule. This rule applies when the earth electrode 14, potential probe 16 and current electrode 18 are in a straight line and properly spaced (for most purposes, the current electrode 18 should be 30 meters to 50 meters from the ground electrode 14 under test), when the soil is homogeneous and when the ground electrode 14 has a small resistance area. Bearing these limitations in mind, this method can ideally be used on small ground electrode systems consisting of a single rod or plate, etc., and on medium systems with several rods.

Since the 62% rule is valid for ideal environmental conditions with consistent geological conditions, as outlined above, it is normal for the operator to verify the measurement result measured at 62% of the distance between the electrodes 14 and 18, by repeating the measurement with the electrode 16 at 52% and 72% of the distance between electrodes 14 and 18 (e.g., repositioning the electrode 16 at 10% of the distance between the electrodes 14 and 18, in either direction). If all three results are similar, the original result obtained at the 62% distance may be considered to be correct. However, should the three results significantly change (e.g., 30% or greater difference), the distance of the electrode 18 from the ground rod 14 being tested is increased before subsequently repeating the measurement procedure. Thus, multiple readings at varying distance placements may be performed for the current electrode 18 to confirm and verify results. Also, with such 3- or 4-pole testing, the main unit 10 of the testing device is typically located at the ground rod 14 to be tested since it is generally necessary to connect the device with the earth electrode 14 via a short lead or conductor. The short lead ensures that its effect is negligible with respect to the leads connecting the electrodes 16 and 18.

Hence, initiating testing and/or indicating measurement results on the remote unit 12 enables a simplified manner of conducting multiple measurements and/or of verifying proper placement of the electrodes 16 and 18 while reducing a considerable amount of effort, which would normally be expended on walking back and forth several times between both of the electrodes 16 and/or 18 and the main unit 10 of the testing device (e.g., in repositioning the electrodes 16 and/or 18 and reinitiating the testing on main unit 10). For example, where results of the measurements indicated on the remote unit 12 are undesirable, for example, an electrode 16 or 18 can be repositioned, and the measurement can be reinitiated from that electrode by clamping the inductance mechanism 30 to the corresponding wire 24 or 26 and reinitiating the test via the remote unit 12 without having to interface directly with the main unit 10.

### Selective Measurement

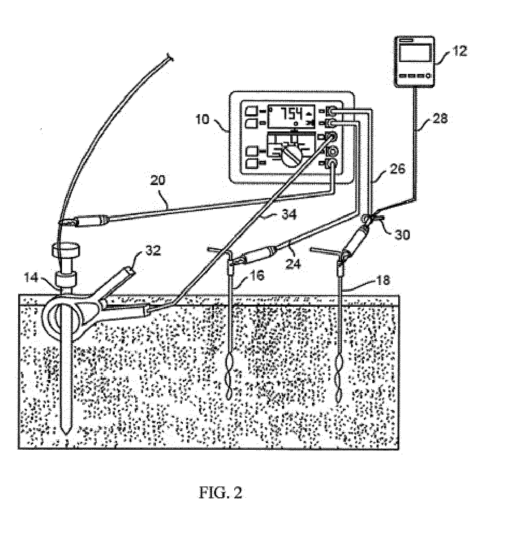

According to another example shown in FIGURE 2, selective measurement may be implemented. This technique is similar to the "fall-of-potential" testing described above in that implementation thereof provides similar measurements as those resulting from the fall-of-potential technique. Applying this technique, however, it is not necessary to disconnect the earth electrode 14 to be tested from its connection to the grounding system (which could alter the voltage potentials of the entire earthing system, which potentially gives cause to incorrect and therefore misleading measurement results). Thus, an operator conducting the selective measurements is no longer required to disconnect the earth ground 14, which should be done with caution. This also reduces risk to other personnel or electrical equipment that may be found within a non-grounded structure.

Similar to the previous embodiment, the two auxiliary electrodes (e.g., current electrode 18 and probe 16), can be placed in the soil, for example in a direct line, at predetermined distances away from the earth electrode 14 being tested as shown in FIGURE 2. As previously described, another common measurement topology (not shown) comprises placing the electrodes 16 and 18 at a different angle to one another (e.g., 90 degrees). The main unit 10 of the testing device is then connected to the earth electrode 14, with the advantage that the connection to the site does not need to be disconnected, as would normally be necessary. According to the example shown in FIGURE 2, a current clamp 32 is connected to the main unit 10 of the testing device via the wire 34 and may be placed around the earth electrode 14 to be tested to ensure that only the resistance of that earth electrode 14 is measured.

For selective measurements, the use of a current clamp 32 then allows the measurement of the exact resistance of an individual earth ground rod 14 (e.g., each ground rod of a building or, for instance, a high-voltage pylon footing). As with the previous embodiment, testing can be initiated at the remote unit 12 by transmitting an induction signal over a wire 26 (e.g., after placing the stake 18 into the ground) using the inductance mechanism 30. It is to be appreciated that the inductance mechanism 30 can be used to initiate the measurement over the wires 20 or 24 as well. The main unit 10 can receive an induction signal over one of the wires 20, 24, or 26 indicating initiation of measurement, and can accordingly generate a known current between the current electrode 18 and the earth electrode 14. The main unit 10 then measures a drop in voltage potential between the probe 16 and the earth electrode 14. However, the main unit 10 measures the current flowing through the earth electrode 14 of interest using the current clamp 32.

As outlined above, generated current can also flow through other parallel resistances, but the main unit 10 uses the current measured by the clamp 32 to calculate a resistance value for the earth electrode 14 of interest according to Ohm's Law (*V* = *IR*). Thus, the current clamp 32 eliminates the effects of parallel resistances in a grounded system. The main unit 10 indicates the resistance value to the remote unit 12 by transmitting an induction signal over one or more of the wires 20, 24, and 26, as described, by which the main unit 10 indicates the resistance value, or a representation thereof, by using a certain modulation, signal strength, or signal transmission pattern for the induction signal.

### Soil Resistivity/Geological Survey

In yet another example, a geological survey may be performed using standard soil resistivity measurements achieved by a four-point or 4-pole test, as illustrated in FIGURE 3, a 3-pole test, a 2-pole test, or a greater number of poles, etc. This technique involves the use of four electrodes 50, 52, 54, and 56 placed into the soil, wherein the two outer electrodes 50 and 56 are used to generate a current and the two inner electrodes 52 and 54 may, in one embodiment, be placed directly along the current path and act as voltage potential probes to measure the drop across the soil being tested. Another alternative arrangement, as discussed beforehand, comprises placing the electrodes at different angles to one another (e.g., staggered). The soil resistivity measurement technique contrasts to the 3- or 4-pole tests of the aforementioned embodiments wherein one of the current electrodes and potential probes are effectively combined in the (short) test lead connecting the main unit 10 of the testing device to the earth electrode 14. In particular, in this embodiment, since the distance of the measurement electrodes 52 and 54 relate to the depth of the investigated soil layer, it is desirable for the area under investigation to be scanned with the measurement probes 52 and 54 in an equidistant manner.

In the example shown in FIGURE 3, four earth ground electrodes (two outer current electrodes 50 and 56 and two inner voltage probes 52 and 54) are positioned in the soil in a straight line, equidistant from one another. The distance between the respective electrodes 50, 52, 54, and 56 can be at least three times greater than the depth of the electrodes below the surface. For example, if the depth of each ground electrode is 30 meters, the distance between the electrodes 50, 52, 54, and 56 may be greater than 91 meters. According to the example in FIGURE 3, the electrodes 50, 52, 54, and 56 are connected to the main unit 10 via the wires 58, 60, 62, and 64, respectively. To calculate the soil resistance, the main unit 10 of the testing device to which the two outer ground electrodes 50 and 56 are connected, generates a known current between the electrodes 50 and 56 (over wires 58 and 64) and the drop in voltage potential is subsequently measured by the two inner probes 52 and 54 (over wires 60 and 62).

Using Ohm's Law *(V* = *IR*), the main unit 10 of the testing device is then able to automatically calculate the soil resistance based on these measurements. As described, the remote unit 12 can initiate the test by transmitting an induction signal on the wire 64 using the inductance mechanism 30 after the stake 56, the last stake in this example, is placed into the ground. The main unit 10 detects the induction signal (and certain characteristics of the signal) and accordingly initiates the soil resistivity test. Following the test, the main unit 10 can indicate a representation of the results thereof by transmitting an induction signal over one or more of the wires 58, 60, 62, or 64, as described, and the remote unit 12 can render the results (or the representation thereof). Moreover, the representation of the results can include an index related to a range of values (e.g., an index 1-8 indicating a range of results), and remote unit 12 can render the representation, as described. Where results are undesirable, for example, an electrode 50, 52, 54, or 56 can be repositioned, and the test can be reinitiated from that electrode by clamping the inductance mechanism 30 to the corresponding wire 58, 60, 62, or 64, and reinitiating the test via the remote unit 12 without having to interface directly with the main unit 10.

For example, measurement results may often be distorted and invalidated by underground pieces of metal, underground aquifers, areas of nonhomogeneous soil, varying depths of bedrock, etc. It may therefore be preferable to perform additional measurements wherein the axes of the electrodes are turned 90 degrees. By changing the depth and distance of the electrodes 50 and 56 and the probes 52 and 54 several times while performing a measurement, it is possible to produce a highly accurate profile that may be used in order to determine an appropriate ground resistance system for a particular area. Thus, the aforementioned embodiments additionally facilitate performing such additional measurements, in particular due to the convenience of the operator not having to consult the main unit 10 of the testing device upon every adjustment, and/or performing each new measurement test procedure as the measurement can be initiated and a representation of results determined via the remote unit 12.

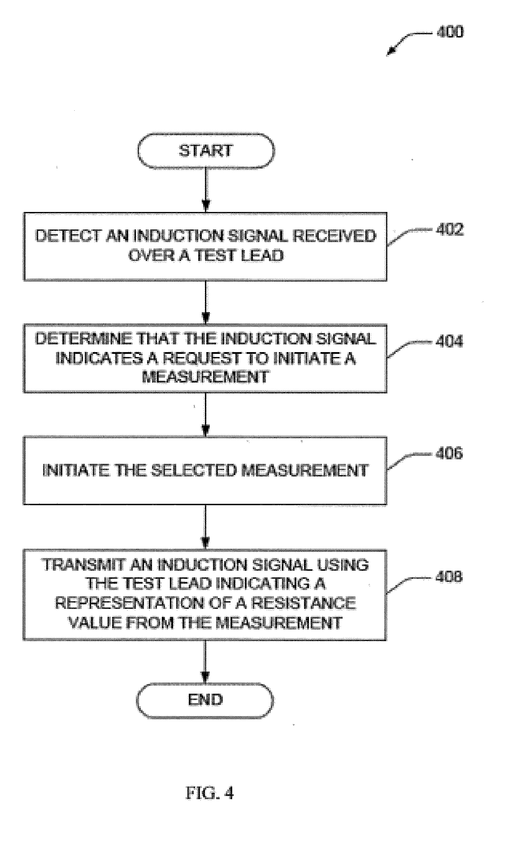

Referring to FIGURES 4-6, methodologies that can be utilized in accordance with various aspects described herein are illustrated. While, for purposes of simplicity of explanation, the methodologies are shown and described as a series of acts, it is to be understood and appreciated that the methodologies are not limited by the order of acts, as some acts can, in accordance with one or more aspects, occur in different orders and/or concurrently with other acts from that shown and described herein. For example, those skilled in the art will understand and appreciate that a methodology could alternatively be represented as a series of interrelated states or events, such as in a state diagram. Moreover, not all illustrated acts may be required to implement a methodology in accordance with one or more aspects.

FIGURE 4 illustrates an example methodology 400 for performing resistance measurements and indicating results via induction signal. At 402, an induction signal received over a test lead can be detected. For example, the induction signal can be transmitted by a remote unit, as described, to initiate a measurement. Thus, at 404, it can be determined that the induction signal indicates a request to initiate a measurement. For example, this can include analyzing one or more characteristics of the signal, such as a modulation, transmission pattern, strength, etc., to determine that the remote unit is requesting the measurement. In other examples, the remote unit or other devices can transmit other induction signals with other characteristics for other purposes.

At 406, the selected measurement is initiated. For example, the selected measurement can be determined based on a position of a selector knob on the main unit. In another example, the selected measurement can be indicated by the remote unit by using varying characteristics for the induction signal. In any case, the measurement is performed, and at 408, an induction signal can be transmitted using the test lead to indicate a representation of a resistance value from the measurement. For example, characteristics of the induction signal can be varied to indicate different representations. In one example, the representation corresponds to a range of resistance values to limit possible representations that can be transmitted over the wire using the test lead.

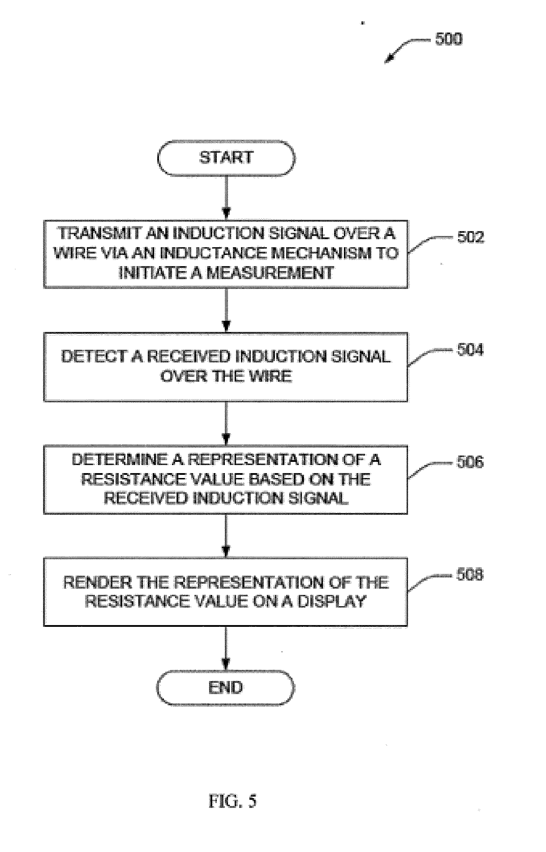

FIGURE 5 illustrates an example methodology 500 for initiating a measurement and presenting results thereof. At 502, an induction signal can be transmitted over a wire via an inductance mechanism to initiate a measurement. For example, the measurement can relate to a ground resistance test for performing by a main unit. Moreover, as described, the induction signal can be transmitted with certain characteristics to indicate initiation of the measurement (e.g., using a certain modulation, pattern, strength, etc.), a type of measurement, etc. At 504, a received induction signal can be detected over the wire. The received induction signal can similarly have characteristics to indicate a representation of a resistance value.

Thus, at 506, a representation of the resistance value can be determined based on the received induction signal. For example, the representation can indicate the resistance value, an index related to a range of resistance values, and/or the like. The representation can be determined based on the received induction signal characteristics, and at 508, the representation of the resistance value can be rendered on a display. This can include displaying a number value of the resistance or a range thereof illuminating a number of lights indicative of a range of the resistance value, and/or the like.

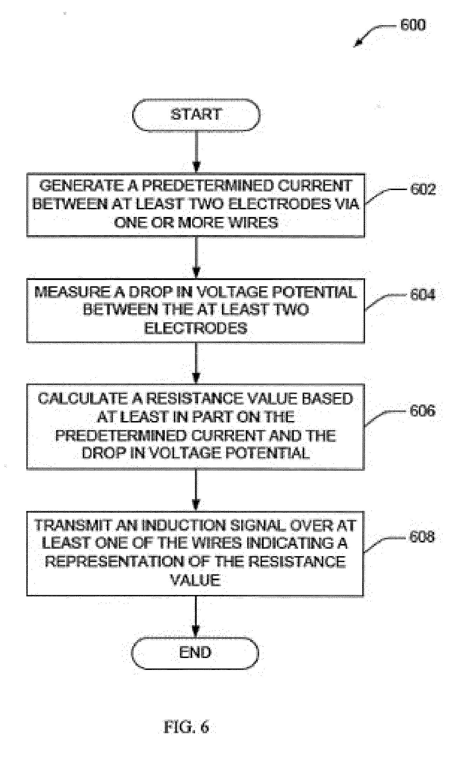

FIGURE 6 illustrates an example methodology 600 for computing and transmitting a representation of a resistance value. At 602, a predetermined current is generated between at least two electrodes via one or more wires. For example, the current can be generated by a testing device connected to the electrodes via the one or more wires. At 604, a drop in voltage potential between the at least two electrodes can be measured. This can be measured based on reading voltage at one or more additional electrodes between the at least two electrodes. At 606, a resistance value can be calculated based at least in part on the predetermined current and the drop in voltage potential. This can include using Ohm's law, as described, to compute the resistance. At 608, an induction signal can be transmitted over at least one of the wires indicating a representation of the resistance value. For example, the representation can be indicated by varying one or more aspects of the signal, such as modulation, transmission pattern, strength, and/or the like, as described. Thus, a remote unit picking up the induction signal can determine and render the representation.

In addition to the above, the skilled person will understand that some of the aforementioned measuring techniques may be conducted as alternating current (AC) or direct current (DC) measurements, and any other suitable techniques required for a specific purpose, such as Kelvin DC measurements, may also be implemented in accordance with the present invention.

While one or more aspects have been described above, it should be understood that any and all equivalent realizations of the presented aspects are included within the scope and spirit thereof. The aspects depicted are presented by way of example only and are not intended as limitations upon the various aspects that can be implemented in view of the descriptions. Thus, it should be understood by those of ordinary skill in this art that the presented subject matter is not limited to these aspects since modifications can be made. Therefore, it is contemplated that any and all such embodiments are included in the presented subject matter as may fall within the scope and spirit thereof.

In one respect, an apparatus for measuring earth ground resistivity, comprises a main unit configured to: couple to each of a plurality of electrodes over a respective wire; perform a resistance measurement over at least a portion of the plurality of electrodes; and transmit an induction signal over one or more of the respective wires indicating a representation of a resistance value calculated as part of the resistance measurement.

The apparatus may be further configured to detect a received induction signal over the one or more of the respective wires, wherein the main unit performs the resistance measurement based at least in part on determining that the received induction signal indicates resistance measurement initiation.

The apparatus may further comprise a remote unit configured to: detect the induction signal over the one or more of the respective wires using an inductance mechanism; process the induction signal to determine the representation of the resistance value; and render the representation of the resistance value on an interface of the remote unit.

Optionally, the interface of the remote unit comprises a digital display for rendering the representation of the resistance value or a series of lights to indicate the representation of the resistance value. The remote unit may be further configured to transmit a measurement initiation induction signal over the one or more of the respective wires using the inductance mechanism to indicate a request to initiate performing the resistance measurement, wherein optionally the remote unit transmits the measurement initiation induction signal based at least in part on detecting activation of a button on the remote unit for performing the resistance measurement, and wherein optionally the remote unit transmits the measurement initiation induction signal with a modulation, transmission pattern, or strength to indicate measurement initiation, particularly to indicate initiation for a specific type of measurement.

In another respect, apparatus for measuring earth ground resistivity, comprises a remote unit configured to: transmit an induction signal over a wire connected between a grounded electrode and a main unit to indicate a request to perform a resistance measurement; detect a received induction signal over the wire; process the received induction signal to determine a representation of a resistance value resulting from the resistance measurement; and render an indication related to the representation of the resistance value.

## Claims

1. An apparatus for measuring earth ground resistivity, comprising:
a main unit configured to:
couple to each of a plurality of electrodes over a respective wire;
perform a resistance measurement over at least a portion of the plurality of electrodes; and
transmit an induction signal over one or more of the respective wires indicating a representation of a resistance value calculated as part of the resistance measurement.

2. Apparatus as claimed in Claim 1, wherein the main unit is further configured to detect a received induction signal over the one or more of the respective wires, wherein the main unit performs the resistance measurement based at least in part on determining that the received induction signal indicates resistance measurement initiation.

3. Apparatus as claimed in Claim 1 or 2, wherein the main unit is configured to perform the resistance measurement at least in part by:
generating a predetermined current between the plurality of electrodes;
measuring a drop in voltage potential between the plurality of electrodes; and
calculating the resistance value based at least in part on the predetermined current and the drop in voltage potential.

4. Apparatus as claimed in Claim 1, 2 or 3 wherein the representation of the resistance value is an index corresponding to a range of the resistance value.

5. Apparatus as claimed in any preceding claim, wherein the main unit transmits the induction signal using a modulation, transmission pattern, or signal strength to indicate the representation of the resistance value.

6. Apparatus as claimed in any preceding claim, further comprising a remote unit configured to:
detect the induction signal over the one or more of the respective wires using an inductance mechanism;
process the induction signal to determine the representation of the resistance value;
and
render the representation of the resistance value on an interface of the remote unit, and, optionally
wherein the interface of the remote unit comprises a digital display for rendering the representation of the resistance value or a series of lights to indicate the representation of the resistance value.

7. Apparatus as claimed in Claim 6, wherein the remote unit is further configured to transmit a measurement initiation induction signal over the one or more of the respective wires using the inductance mechanism to indicate a request to initiate performing the resistance measurement, and, optionally,
wherein the remote unit transmits the measurement initiation induction signal based at least in part on detecting activation of a button on the remote unit for performing the resistance measurement, and/or
wherein the remote unit transmits the measurement initiation induction signal with a modulation, transmission pattern, or strength to indicate measurement initiation, and/or
wherein said measurement initiation induction signal optionally indicates initiation for a selective type of measurement.

8. A remote unit for indicating earth ground resistivity, suitable for use with the apparatus of any of claims 1 to 7, wherein the remote unit comprises an inductance mechanism and is configured to:
transmit an induction signal along a wire to indicate a request to perform a resistance measurement;
detect a received induction signal; and
process the received induction signal to determine a representation of a resistance value resulting from a resistance measurement.

9. A remote unit as claimed in Claim 8, further comprising an interface on which the remote unit is configured to render an indication related to the representation of the resistance value.

10. A remote unit as claimed in Claim 8, wherein the interface of the remote unit comprises a digital display for rendering the representation of the resistance value or a series of lights to indicate the representation of the resistance value.

11. A method of measuring earth ground resistivity using a main unit and a remote unit, the method comprising:
generating a predetermined current between at least two electrodes over one or more respective wires;
measuring a drop in voltage potential between two or more of the at least two electrodes;
calculating a resistance value based at least in part on the predetermined current and the drop in voltage potential; and
the main unit transmitting to the remote unit an induction signal over at least one of the one or more respective wires indicating a representation of the resistance value.

12. A method as claimed in Claim 11, further comprising receiving, from the remote unit, a test initiation induction signal over said one or more respective wires, wherein the generating is based at least in part on the test initiation induction signal.

13. A method as claimed in Claim 11 or 12,
wherein the transmitting comprises varying one or more of a modulation, transmission pattern, or strength of the induction signal to indicate the representation of the resistance value, and/or
wherein the representation of the resistance value is an index corresponding to a range of the resistance value.

14. A method as claimed in any of Claims 10 to 13, further comprising:
detecting, at the remote unit, the transmitted induction signal using an inductance mechanism;
determining the representation of the resistance value indicated by the transmitted induction signal; and
rendering the representation of the resistance value on an interface of the remote unit.

15. A method as claimed in Claim 14, wherein the rendering comprises activating a number of lights indicative of the representation of the resistance value, and/or wherein the transmitting is based at least in part on detecting activation of a button to initiate the resistance measurement.
